# EUROPÄISCHE PATENTSCHRIFT

(11) **EP 1 968 073 B1**
(45) Veröffentlichungstag und Bekanntmachung des Hinweises auf die Patenterteilung: **27.11.2013**
(21) Anmeldenummer: 08003256.8
(22) Anmeldetag: 22.02.2008
(51) Int. Cl.: G11C 16/10

(54) **Verfahren zum Einschreiben von Daten in einen Speicher eines tragbaren Datenträgers**
Method for writing data onto the memory of a portable data carrier
Procédé destiné à l'écriture de données dans la mémoire d'un support de données portatif

(30) Priorität: 09.03.2007 DE 102007011638
(43) Veröffentlichungstag der Anmeldung: 10.09.2008
(73) Patentinhaber: Giesecke & Devrient GmbH, 81677 München (DE)
(72) Erfinder: Grebe, Alexander, 84405 Dorfen (DE); Mamuzic, Nikola, 81829 München (DE); Fiedler, Alexander, 81677 München (DE); Flammensböck, Christian, 86529 Schrobenhausen (DE)

(56) Entgegenhaltungen:
- US-A1- 2003 163 629
- US-A1- 2005 055 493

## Beschreibung

Die Erfindung betrifft ein Verfahren zum Einschreiben von Daten in einen Speicher eines tragbaren Datenträgers. Weiterhin betrifft die Erfindung einen tragbaren Datenträger.

Tragbare Datenträger, die insbesondere als Chipkarten ausgebildet sein können, werden beispielsweise im Bereich des Zahlungsverkehrs, im Mobilfunkbereich, als Ausweisdokumente, als sonstige Sicherheitsdatenträger usw. eingesetzt. Derartige tragbare Datenträger verfügen über einen Speicher zur Speicherung von Daten, die beispielsweise ein Betriebssystem, ein Anwendungsprogramm, persönliche Daten des Inhabers des tragbaren Datenträgers usw. repräsentieren können. Der Speicher kann ganz oder teilweise als ein nichtflüchtiger Speicher ausgebildet sein, der immer wieder neu beschrieben werden kann und dessen Speicherinhalt auch dann erhalten bleibt, wenn der tragbare Datenträger nicht mit einer Betriebsspannung versorgt wird.

Das Einschreiben von Daten in einen gebräuchlichen nicht flüchtigen Speicher eines tragbaren Datenträgers nimmt allerdings relativ viel Zeit in Anspruch und kann insbesondere bei großen Datenmengen eine erhebliche Wartezeit zur Folge haben.

Aus der DE 199 28 468 C2 ist ein Verfahren bekannt, das ein zeitoptimiertes Einschreiben von Daten in einen programmierbaren Festwertspeicher eines mikroprozessorgestützten, tragbaren Datenträgers ermöglichen soll. Bei dem bekannten Verfahren werden die Daten Blockweise von einem Programmiergerät sequentiell an den tragbaren Datenträger gesendet und vor dem Einschreiben in den Festwertspeicher in einem I/O-Puffer zwischengespeichert. Dann wird jeweils ein Datenblock vom I/O-Puffer in einen Programmier-Zwischenspeicher kopiert und der nächste Datenblock im I/O-Puffer empfangen, während zumindest teilweise gleichzeitig die Programmierung des Festwertspeichers mit den Daten des zuvor empfangenen Datenblocks aus dem Programmier-Zwischenspeicher erfolgt.

US 2003/0163629 A1 und US 2005/0055493 A1 zeigen die Merkmale des Oberbegriffes der unabhängigen Ansprüche.

Der Erfindung liegt die Aufgabe zugrunde, auf möglichst optimale Weise Daten in einen Speicher eines tragbaren Datenträgers einzuschreiben.

Diese Aufgabe wird durch ein Verfahren gemäß Anspruch 1 und einen tragbaren Datenträger gemäß Anspruch 7 gelöst.

Beim erfindungsgemäßen Verfahren zum Einschreiben von Daten in einen Speicher eines tragbaren Datenträgers werden erste Daten an den tragbaren Datenträger übermittelt und in einen ersten Eingangspuffer des tragbaren Datenträgers eingeschrieben. Weiterhin werden zweite Daten an den tragbaren Datenträger übermittelt und in einen zweiten Eingangspuffer des tragbaren Datenträgers eingeschrieben. Wenigstens ein Teil der ersten Daten wird aus dem ersten Eingangspuffer ausgelesen und in den Speicher eingeschrieben, während die zweiten Daten an den tragbaren Datenträger übermittelt und in den zweiten Eingangspuffer des tragbaren Datenträgers eingeschrieben werden.

Die Erfindung hat den Vorteil, dass sie ein schnelles Einschreiben der an den tragbaren Datenträger übermittelten Daten in den Speicher des tragbaren Datenträgers ermöglicht.

Besonders vorteilhaft ist es, wenn die an den tragbaren Datenträger übermittelten Daten ohne vorherige Zwischenspeicherung direkt in den ersten Eingangspuffer oder in den zweiten Eingangspuffer eingeschrieben werden.

Dadurch kann die Zeit für ein internes Umkopieren der Daten innerhalb des tragbaren Datenträgers eingespart werden. Außerdem ist kein zusätzlicher Speicherplatz für eine derartige Zwischenspeicherung der Daten erforderlich.

Weiterhin können die aus dem ersten Eingangspuffer ausgelesenen Daten ohne weitere Zwischenspeicherung in den Speicher eingeschrieben werden. Diese Maßnahme trägt ebenfalls zu einem schnellen Einschreiben der übermittelten Daten in den Speicher des tragbaren Datenträgers bei und hat als weiteren Vorteil, dass kein Speicherplatz für eine zusätzliche Zwischenspeicherung der Daten benötigt wird.

Für die Übermittlung der Daten an den tragbaren Datenträger und für das Einschreiben der Daten in den Speicher des tragbaren Datenträgers können Datenblöcke unterschiedlicher Größe verwendet werden. Insbesondere können für die Übermittlung der Daten an den tragbaren Datenträger kleinere Datenblöcke verwendet werden als für das Einschreiben der Daten in den Speicher des tragbaren Datenträgers. Auf diese Weise kann eine optimale Anpassung der Datenblockgröße an die Spezifikationen des Speichers erfolgen und dadurch pro Schreibzyklus die maximal mögliche Datenblockgröße eingeschrieben werden. Gleichzeitig können etwaige Vorgaben hinsichtlich der Datenübermittlung zum tragbaren Datenträger eingehalten werden.

Die Daten können insbesondere im Rahmen einer Initialisierung und/oder eine Personalisierung des tragbaren Datenträgers an den tragbaren Datenträger übermittelt und in den Speicher eingeschrieben werden. Angesichts der dabei einzuschreibenden großen Datenmengen ist ein schnelles Einschreiben besonders wichtig.

Die Anzahl der Eingangspuffer kann nach der Durchführung der Initialisierung und/oder Personalisierung reduziert werden. Insbesondere kann die Anzahl der Eingangspuffer auf einen einzigen Eingangspuffer reduziert werden. In der Regel werden nach der Initialisierung und/ oder Personalisierung nur noch vergleichsweise kleine Datenmengen in den Speicher des tragbaren Datenträgers eingeschrieben, so dass es von Vorteil ist, den für die Eingangspuffer vorgesehenen Speicherplatz teilweise anderweitig zu nutzen. Dadurch kann eine gute Ausnutzung des vorhandenen Speicherplatzes über die gesamte Lebensdauer des tragbaren Datenträgers erzielt werden und die Speicherplatzgröße in einem vertretbaren Rahmen gehalten werden.

Der erfindungsgemäße tragbarer Datenträger weist einen Speicher und mehrere wenigstens temporär vorhandene Eingangspuffer zum Zwischenspeichern von Daten auf, die dem tragbaren Datenträger zum Einschreiben in den Speicher übermittelt werden. Weiterhin weist der erfindungsgemäße tragbare Datenträger eine Funktionalität zum alternierenden Einschreiben der übermittelten Daten in die Eingangspuffer und zum alternierenden Auslesen der Eingangspuffer und Einschreiben der ausgelesenen Daten in den Speicher auf.

Das Einschreiben der übermittelten Daten in einen ersten Eingangspuffer und das Auslesen eines vom ersten Eingangspuffer verschiedenen zweiten Eingangspuffers können zeitlich überlappen.

Der Speicher und die Eingangspuffer können als physikalisch unterschiedliche Speichermedien ausgebildet sein. Dies ermöglicht es, jeweils ein Speichermedium mit vorteilhaften Eigenschaften für die jeweilige Nutzungsart vorzusehen. Beispielsweise kann vorgesehen sein, dass in die Eingangspuffer pro Zeiteinheit eine größere Datenmenge einschreibbar ist als in den Speicher. Dadurch kann die für den Speichervorgang insgesamt benötigte Zeit nahezu auf die reine Einschreibzeit des Speichers reduziert werden. Der Speicher kann als ein nichtflüchtiges Speichermedium ausgebildet sein. Die Eingangspuffer können jeweils als ein flüchtiges Speichermedium ausgebildet sein. Dadurch kann eine dauerhafte Speicherung der übermittelten Daten erreicht und gleichzeitig eine unnötige Beanspruchung des nichtflüchtigen Speichers vermieden werden.

Die Eingangspuffer können als voneinander separierte Speicherbereiche ausgebildet sein. Dies erleichtert die Realisierung eines getrennten Zugriffs und bietet Optionen beispielsweise hinsichtlich einer variablen Größe der Eingangspuffer.

Die Anzahl der Eingangspuffer kann variieren. Dabei kann während eines ersten Zeitraums eine größere Zahl von Eingangspuffern vorhanden sein als während eines zweiten Zeitraums. Insbesondere kann während des zweiten Zeitraums ein einziger Eingangspuffer vorhanden sein. Dadurch lässt sich die Speicherbelegung des tragbaren Datenträgers optimieren. Der erste Zeitraum kann eine Produktionsphase umfassen, während der eine Initialisierung- und/oder Personalisierung des tragbaren Datenträgers durchgeführt wird. Der zweite Zeitraum kann auf den ersten Zeitraum folgen. Dadurch ist es möglich, Speicherbereiche während der Produktionsphase als Eingangspuffer zu nutzen, die beim späteren Einsatz des tragbaren Datenträgers beispielsweise zur Ausführung eines Anwendungsprogramms benötigt werden.

Der tragbare Datenträger kann für eine direkte Einschreibung der übermittelten Daten in die Eingangspuffer ohne vorgeschaltete Zwischenspeicherung und/ oder für ein direktes Einschreiben der aus den Eingangspuffern ausgelesenen Daten in den Speicher ohne vorgeschaltete Zwischenspeicherung ausgelegt sein. Dies bringt Vorteile hinsichtlich der Geschwindigkeit und hinsichtlich des benötigten Speicherplatzes.

Beispielsweise ist der tragbare Datenträger als eine Chipkarte ausgebildet.

Die Erfindung wird nachstehend anhand der in der Zeichnung dargestellten Ausführungsbeispiele erläutert.

Es zeigen:
- Fig. 1: ein stark vereinfachtes Blockschaltbild für ein Ausführungsbeispiel eines tragbaren Datenträgers,
- Fig. 2: einen Ausschnitt aus dem flüchtigen Speicher des tragbaren Datenträgers in einer stark vereinfachten Prinzipdarstellung,
- Fig. 3, 4, 5: Momentaufnahmen des flüchtigen Speichers und des nichtflüchtigen Speichers des tragbaren Datenträgers während der Durchführung des erfindungsgemäßen Verfahrens in einer stark vereinfachten Prinzipdarstellung.

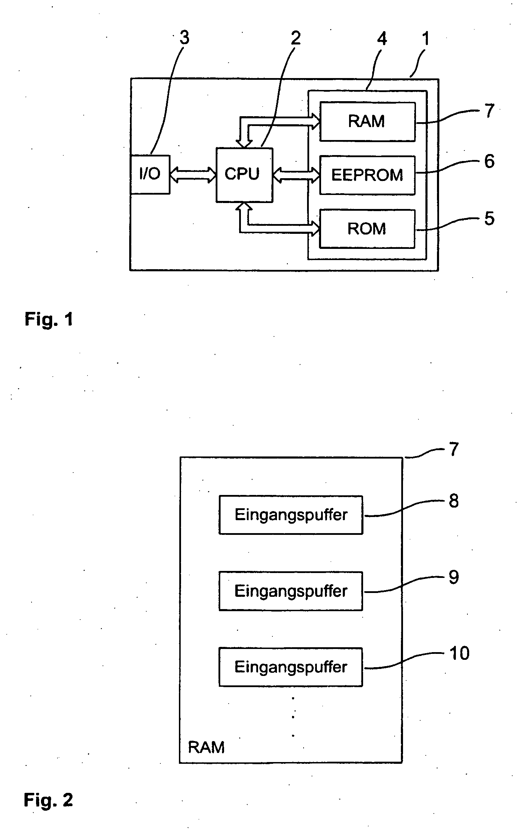

Fig.1 zeigt ein stark vereinfachtes Blockschaltbild für ein Ausführungsbeispiel eines tragbaren Datenträgers 1. Dabei ist als ein tragbarer Datenträger 1 im Sinn der Erfindung ein Rechnersystem anzusehen, bei dem die Ressourcen, d. h. Speicherressourcen und/ oder Rechenkapazität (Rechenleistung) begrenzt sind, z. B. eine Chipkarte (Smart Card, Mikroprozessor-Chipkarte) oder ein Token oder ein Chipmodul zum Einbau in eine Chipkarte oder in ein Token. Der tragbare Datenträger 1 kann eine beliebige standardisierte oder nicht standardisierte Gestalt haben, beispielsweise die Gestalt einer flachen Chipkarte ohne Norm oder nach einer Norm wie z.B. ISO 7810 (z.B. ID-1, ID-00, ID-000) oder die eines volumigen Tokens.

Der tragbare Datenträger 1 weist eine Prozessoreinheit 2 auf, welche die Funktionsabläufe des tragbaren Datenträgers 1 steuert und auch als Central Processing Unit, abgekürzt CPU, bezeichnet wird. Weiterhin weist der tragbare Datenträger 1 eine Schnittstelle 3 zur Ein- und Ausgabe von Daten und einen Speicherbaustein 4 auf. Beim dargestellten Ausführungsbeispiel weist der Speicherbaustein 4 einen Permanentspeicher 5, einen nichtflüchtigen Speicher 6 und einen flüchtigen Speicher 7 auf. Alternativ dazu ist auch ein anderer Aufbau des Speicherbausteins 4 möglich. Die Prozessoreinheit 2 ist mit der Schnittstelle 3, dem Permanentspeicher 5, dem nichtflüchtigen Speicher 6 und dem flüchtigen Speicher 7 verbunden.

Die Schnittstelle 3 dient der Kommunikation mit externen Geräten, die durch eine berührende Kontaktierung des tragbaren Datenträgers 1 und/oder kontaktlos abgewickelt werden kann. Die Prozessoreinheit 2, die Schnittstelle 3 und der Speicherbaustein 4 können Bestandteile eines integrierten Schaltkreises, insbesondere eines Mikroprozessors sein. Ebenso ist es auch möglich, eine oder mehrere dieser Komponenten als separate Bauteile auszubilden. Auch die Bestandteile des Speicherbausteins 4 können entweder als ein gemeinsames Bauteil oder als mehrere separate Bauteile ausgebildet sein.

Im Permanentspeicher 5 sind Daten abgelegt, die während der gesamten Lebensdauer des tragbaren Datenträgers 1 unverändert erhalten bleiben, beispielsweise Programme, Parameter, personenbezogene Angaben, Schlüssel usw. Insbesondere ist im Permanentspeicher 5 das Betriebssystem des tragbaren Datenträgers 1 gespeichert.

Der flüchtige Speicher 7 dient als Arbeitsspeicher für die Prozessoreinheit 2, so dass geheime Daten beispielsweise bei der Durchführung von Berechnungen im flüchtigen Speicher 7 zwischengespeichert werden. Im flüchtigen Speicher 7 bleibt der Speicherinhalt nur solange erhalten, wie der tragbare Datenträger 1 mit einer Betriebsspannung versorgt wird.

Der nichtflüchtige Speicher 6 kann während der Lebensdauer des tragbaren Datenträgers 1 immer wieder neu beschrieben werden. Der jeweilige Speicherinhalt bleibt auch dann erhalten, wenn der tragbare Datenträger 1 nicht mit der Betriebsspannung versorgt wird. Im nichtflüchtigen Speicher 6 sind beispielsweise Ergänzungen zum Betriebssystem, Anwendungssoftware, Schlüssel, personenbezogene Daten usw. abgelegt.

Fig. 2 zeigt einen Ausschnitt aus dem flüchtigen Speicher 7 des tragbaren Datenträgers 1 in einer stark vereinfachten Prinzipdarstellung. Im dargestellten Ausschnitt des flüchtigen Speichers 7 sind beispielhaft drei Eingangspuffer 8, 9, 10 zur Zwischenspeicherung von Daten abgebildet. Für jeden der Eingangspuffer 8, 9, 10 ist ein Teilbereich des flüchtigen Speichers 7 reserviert, der entweder eine fest vorgegebene oder eine variable Größe aufweist. Die Eingangspuffer 8, 9, 10 können beliebig im flüchtigen Speicher 7 angeordnet sein und zeichnen sich dadurch aus, dass sie sehr schnell beschrieben und ausgelesen werden können. Insbesondere können die Eingangspuffer 8, 9, 10 voneinander separiert im flüchtigen Speicher 7 angeordnet sein, so dass durch die Eingangspuffer 8, 9, 10 kein zusammenhängender Bereich des flüchtigen Speichers 7 belegt wird. Die Größe jedes Eingangspuffers 8, 9, 10 entspricht vorzugsweise wenigstens der maximalen Datenblockgröße des tragbaren Datenträgers 1.

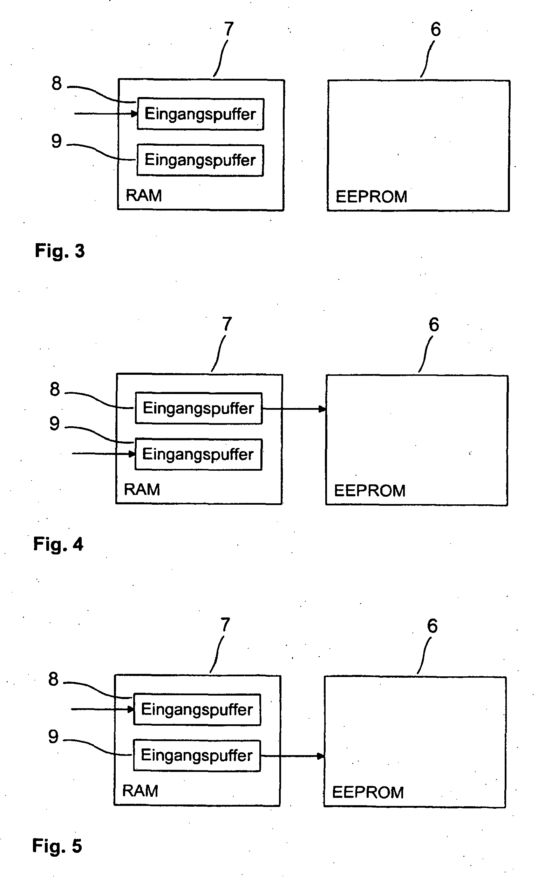

Beispielsweise im Rahmen einer Initialisierung und/ oder einer Personalisierung des tragbaren Datenträgers 1 kann es erforderlich sein, Daten die dem tragbaren Datenträger 1 von einem externen Gerät übermittelt werden, in den nichtflüchtigen Speicher 6 des tragbaren Datenträgers 1 einzuschreiben. Mit den im Rahmen der Erfindung vorgesehenen mehreren Eingangspuffern 8, 9,10 lässt sich das Einschreiben der vom externen Gerät übermittelten Daten in den nichtflüchtigen Speicher 6 des tragbaren Datenträgers 1 sehr effizient gestalten. Dies wird im Folgenden anhand der Fig. 3 bis 5 für ein Ausführungsbeispiel des tragbaren Datenträgers 1 näher erläutert, bei dem zwei Eingangspuffer 8, 9 vorgesehen sind. Diese Vorgehensweise lässt sich unmittelbar auch auf eine größere Zahl von Eingangspuffern übertragen.

Die Fig. 3 bis 5 zeigen Momentaufnahmen des flüchtigen Speichers 7 und des nichtflüchtigen Speichers 6 des tragbaren Datenträgers 1 während der Durchführung des erfindungsgemäßen Verfahrens in einer stark vereinfachten Prinzipdarstellung. Die zum Zeitpunkt der Momentaufnahmen vorhandenen Datenströme sind durch Pfeile dargestellt.

Wie in Fig. 3 dargestellt, werden die vom externen Gerät übermittelten Daten zunächst in den Eingangspuffer 8 eingeschrieben. Die Daten werden beispielsweise mittels einer APDU (Application Protocol Data Unit) vom externen Gerät an den tragbaren Datenträger 1 übermittelt. Um ein Umkopieren der Daten zu vermeiden, können die vom externen Gerät übermittelten Daten direkt, d. h. ohne eine vorherige Zwischenspeicherung, in den Eingangspuffer 8 eingeschrieben werden. Nach dem Eingang der APDU übermittelt der tragbare Datenträger 1 dem externen Gerät eine Eingangsbestätigung. Daraufhin übermittelt das externe Gerät eine weitere APDU an den tragbaren Datenträger 1. Der nichtflüchtige Speicher 6 wird zu dem in Fig. 3 dargestellten Zeitpunkt noch nicht mit Daten versorgt.

Wenn die Speicherkapazität des Eingangspuffers 8 erschöpft ist, werden die vom externen Gerät übermittelten Daten nicht mehr in den Eingangspuffer 8, sondern in den Eingangspuffer 9 eingeschrieben. Dies kann beispielsweise bereits nach der ersten vom tragbaren Datenträger 1 empfangenen APDU der Fall sein. Dann wird nach dem Empfang des Instruction Bytes der zweiten APDU das Auslesen des Eingangspuffers 8 und das Einschreiben in den nichtflüchtigen Speicher 6 gestartet. Dies ist in Fig. 4 dargestellt. Das Umschalten des Einschreibens vom Eingangspuffer 8 zum Eingangspuffer 9 kann auch schon zu einem früheren Zeitpunkt erfolgen oder von einer anderen Bedingung getriggert werden. Beispielsweise kann das Umschalten nach jeder empfangenen APDU erfolgen.

Während des Einschreibens der vom externen Gerät übermittelten Daten in den Eingangspuffer 9 werden die im Eingangspuffer 8 zwischengespeicherten Daten ausgelesen und in den nichtflüchtigen Speicher 6 eingeschrieben. Das Einschreiben sämtlicher im Eingangspuffer 8 zwischengespeicherten Daten in den nichtflüchtigen Speicher 6 wird in der Regel länger dauern als das Übermitteln der Daten vom externen Gerät zum tragbaren Datenträger 1 und das Einschreiben der übermittelten Daten in den Eingangspuffer 9. In der Regel wird sich daher nach dem Füllen des Eingangspuffers 9 mit den übermittelten Daten eine Wartezeit ergeben bis der Eingangspuffer 8 durch Einschreiben der darin zwischengespeicherten Daten in den nichtflüchtigen Speicher 6 geleert ist.

Wenn die zweite APDU vollständig empfangen wurde und das Einschreiben der Daten der ersten APDU in den nichtflüchtigen Speicher 6 erfolgreich abgeschlossen wurde, übermittelt der tragbare Datenträger 1 dem externen Gerät eine Empfangsbestätigung für die zweite APDU. Dann wird damit begonnen die im Eingangspuffer 9 gespeicherten Daten in den nichtflüchtigen Speicher 6 einzuschreiben und die nunmehr vom externen Gerät übermittelten Daten in den Eingangspuffer 8 einzuschreiben. Diese Situation ist in Fig. 5 dargestellt.

Auf die vorstehend beschriebene Weise wird fortgefahren, bis die Datenübermittlung vom externen Gerät an den tragbaren Datenträger 1 zum Zwecke der Einschreibung in den nichtflüchtigen Speicher 6 abgeschlossen ist. Dabei ist es gemäß einer Variante auch möglich, jeweils unmittelbar nach Empfang der Daten mit dem Einschreiben der jeweils vorherigen Daten in den nichtflüchtigen Speicher 6 zu beginnen und sofort eine Eingangsbestätigung an das externe Gerät zu senden, um die Übermittlung der nächsten APDU zu veranlassen. Unabhängig von der gewählten Variante werden die übermittelten Daten jeweils abwechselnd in den Eingangspuffer 8 und in den Eingangspuffer 9 eingeschrieben und genau gegenläufig dazu die im Eingangspuffer 9 bzw. im Eingangspuffer 8 zwischengespeicherten Daten ausgelesen und in den nichtflüchtigen Speicher 6 eingeschrieben. Durch die alternierende Verwendung des Eingangspuffers 8 und des Eingangspuffers 9 kann ein kontinuierliches Einschreiben von Daten in den nichtflüchtigen Speicher 6 erreicht werden und dadurch die insgesamt für das Übermitteln der Daten vom externen Gerät an den tragbaren Datenträger 1 und das Einschreiben der Daten in den nichtflüchtigen Speicher 6 des tragbaren Datenträgers 1 benötigte Zeit im Wesentlichen auf die für das reine Einschreiben in den nichtflüchtigen Speicher 6 benötigte Zeit reduziert werden.

Dabei ist es auch möglich für die Übermittlung an den tragbaren Datenträger 1 kleinere Datenblöcke zu verwenden als für das Einschreiben in den nichtflüchtigen Speicher 6. Die für das Einschreiben verwendete Datenblockgröße hängt von den Spezifikationen des nichtflüchtigen Speichers 6 ab und entspricht vorzugsweise der maximalen Datenblockgröße, die in einem Schreibzyklus eingeschrieben werden kann. Da die Übermittlung der Daten während des Einschreibens von bereits übermittelten Daten in den nichtflüchtigen Speicher 6 erfolgt, wird für die Übermittlung keine zusätzliche Zeit benötigt.

Um diesen Zeitgewinn zu ermöglichen, ist der tragbare Datenträger 1 so ausgebildet, dass eine Programmausführung während des Einschreibens in den nichtflüchtigen Speicher 6 möglich ist. Die Programmausführung kann über den Permanentspeicher 5 oder den flüchtigen Speicher 7 abgewickelt werden. Das Ende einer Einschreibsequenz in den nichtflüchtigen Speicher 6 kann durch einen Interrupt oder durch das Setzen von Flags angezeigt werden, die während der Programmausführung regelmäßig abgefragt werden.

Die Steuerung der Verwendung der einzelnen Eingangspuffer 8, 9,10 kann jeweils durch das Betriebssystem erfolgen. Um jeweils kenntlich zu machen, in welchen Eingangspuffer 8, 9,10 die übermittelten Daten gerade eingeschrieben werden und aus welchen Eingangspuffer 8, 9, 10 die zwischengespeicherten Daten zum Einschreiben in den nichtflüchtigen Speicher 6 ausgelesen werden, kann ein separates oder den Eingangspuffern 8, 9,10 jeweils zugeordnetes Datenelement vorgesehen werden. Dieses Datenelement zeigt an, welcher Eingangspuffer 8, 9,10 jeweils zu welchem Zweck zu verwenden ist.

Im Rahmen der Erfindung kann vorgesehen sein, dass beispielsweise die Eingangpuffer 9, 10 nur temporär vorhanden sind und ansonsten lediglich mit dem Eingangspuffer 8 gearbeitet wird. Insbesondere werden mehrere Eingangspuffer 8, 9, 10 vorgesehen, wenn große Datenmengen von einem externen Gerät an den tragbaren Datenträger 1 übermittelt und in den nichtflüchtigen Speicher 6 eingeschrieben werden sollen. Dies ist beispielsweise während der Produktionsphase des tragbaren Datenträgers 1, insbesondere bei der Initialisierung und/ oder der Personalisierung, der Fall. Es kann daher vorgesehen sein, während der Produktionsphase des tragbaren Datenträgers 1 zwei oder mehr Eingangspuffer 8, 9,10 vorzusehen und nach der Produktionsphase beispielsweise nur noch den Eingangspuffer 8 beizubehalten. Der für die anderen Eingangspuffer 9, 10 reservierte Speicherplatz im flüchtigen Speicher 7 wird dann nicht mehr benötigt und kann für andere Zwecke freigegeben werden.

Zusätzlich oder alternativ zu den vorstehend beschriebenen Maßnahmen können weitere Maßnahmen vorgesehen sein, um das Einschreiben in den nichtflüchtigen Speicher 6 des tragbaren Datenträgers 1 möglichst optimal zu gestalten.

Beispielsweise können Maßnahmen vorgesehen sein, um einen möglichst großen Bereich des nichtflüchtigen Speichers 6 adressieren zu können. Wenn für die Datenübermittlung zum tragbaren Datenträger 1 herkömmliche AP-DUs verwendet werden, stehen für die Adressierung zwei Bytes zur Verfügung, so dass maximal ein 64 Kilobyte großer Datenblock adressiert werden kann.

Eine Möglichkeit, die Grenze von 64 Kilobyte zu überschreiten, besteht in einem Shift der Adressinformation. Allerdings kann in diesem Fall nicht mehr jedes einzelne Byte des nichtflüchtigen Speichers 6 adressiert werden.

Eine weitere Möglichkeit besteht darin, das Instruction Byte der APDU für eine Erweiterung des Adressbereichs heranzuziehen. In den vier höherwertigen Bits des Instruction Byte könnte der jeweilige Befehl gespeichert werden, den das Instruction Byte verkörpert. Mit den vier niederwertigen Bits könnten dann sechzehn Seiten à 64 Kilobyte adressiert werden.

Weiterhin besteht die Möglichkeit, eine spezielle APDU vorzusehen, mit der die Startadresse eines 64 Kilobyte Datenblocks vorgegeben werden kann. Für jeden 64 Kilobyte Datenblock muss je eine APDU mit der Startadresse des Datenblocks an den tragbaren Datenträger 1 übermittelt werden. Auf diese Weise stehen vier Byte für die Adressierung zur Verfügung, so dass insgesamt 4 Gigabyte Daten adressiert werden können. Alternativ zur Übermittlung der Startadressen für die Datenblöcke ist auch eine automatische Inkrementation der Startadressen im tragbaren Datenträger 1 möglich.

Um möglichst viele Daten pro Zeiteinheit in den nichtflüchtigen Speicher 6 einzuschreiben, kann vorgesehen werden, dass jeweils ganze Seiten in den nichtflüchtigen Speicher 6 eingeschrieben werden und dadurch die Anzahl der Schreiboperationen minimiert wird. Dies wird durch einen internen Cache Speicher des tragbaren Datenträgers 1 ermöglicht, in dem die an den tragbaren Datenträger 1 übermittelten Daten zwischengespeichert werden, bis jeweils eine vollständige Seite vorhanden ist, die dann in einer Schreiboperation in den nichtflüchtigen Speicher 6 eingeschrieben wird. Ein seitenweises Einschreiben von Daten in den nichtflüchtigen Speicher 6 ist dann unabhängig von der für die Datenübermittlung zum tragbaren Datenträger 1 verwendeten Blocklänge möglich. Das beschriebene Caching lässt sich sehr effizient im Zusammenhang mit den im Rahmen der Erfindung vorgesehenen Eingangspuffern 8, 9,10 einsetzen, da durch mehrere Eingangspuffer 8, 9, 10 die Wartezeit, die bis zur vollständigen Übermittlung einer Seite an den tragbaren Datenträger 1 erforderlich ist, für das Einschreiben der zuvor übermittelten Seite in den nichtflüchtigen Speicher 6 genutzt werden kann.

Die vorstehend beschriebenen Maßnahmen können jeweils sowohl einzeln als auch in Kombination angewendet werden.

## Patentansprüche

1. Verfahren zum Einschreiben von Daten in einen Speicher (6) eines tragbaren Datenträgers (1), wobei
- erste Daten an den tragbaren Datenträger (1) übermittelt und in einen ersten Eingangspuffer (8) des tragbaren Datenträgers (1) eingeschrieben werden,
- zweite Daten an den tragbaren Datenträger (1) übermittelt und in einen zweiten Eingangspuffer (9) des tragbaren Datenträgers (1) eingeschrieben werden und
- wenigstens ein Teil der ersten Daten aus dem ersten Eingangspuffer (8) ausgelesen und in den Speicher (6) eingeschrieben wird, während die zweiten Daten an den tragbaren Datenträger (1) übermittelt und in den zweiten Eingangspuffer (9) des tragbaren Datenträgers (1) eingeschrieben werden, **dadurch gekennzeichnet,**
**dass** die Daten im Rahmen einer Initialisierung und/oder eine Personalisierung des tragbaren Datenträgers (1) an den tragbaren Datenträger (1) übermittelt und in den Speicher (6) eingeschrieben werden und dass die Anzahl der Eingangspuffer (8, 9, 10) nach der Durchführung der Initialisierung und/ oder Personalisierung reduziert wird.

2. Verfahren nach Anspruch 1, **dadurch gekennzeichnet, dass** die an den tragbaren Datenträger (1) übermittelten Daten ohne vorherige Zwischenspeicherung direkt in den ersten Eingangspuffer (8) oder in den zweiten Eingangspuffer (9) eingeschrieben werden.

3. Verfahren nach einem der vorhergehenden Ansprüche, **dadurch gekennzeichnet, dass** die aus dem ersten Eingangspuffer (8) ausgelesenen Daten ohne weitere Zwischenspeicherung in den Speicher (6) eingeschrieben werden.

4. Verfahren nach einem der vorhergehenden Ansprüche, **dadurch gekennzeichnet, dass** für die Übermittlung der Daten an den tragbaren Datenträger (1) und für das Einschreiben der Daten in den Speicher (6) des tragbaren Datenträgers (1) Datenblöcke unterschiedlicher Größe verwendet werden.

5. Verfahren nach einem der vorhergehenden Ansprüche, **dadurch gekennzeichnet, dass** für die Übermittlung der Daten an den tragbaren Datenträger (1) kleinere Datenblöcke verwendet werden als für das Einschreiben der Daten in den Speicher (6) des tragbaren Datenträgers (1).

6. Verfahren nach einem der vorhergehenden Ansprüche, **dadurch gekennzeichnet, dass** die Anzahl der Eingangspuffer (8, 9, 10) auf einen einzigen Eingangspuffer (8, 9, 10) reduziert wird.

7. Tragbarer Datenträger mit
- einem Speicher (6),
- mehreren wenigstens temporär vorhandenen Eingangspuffern (8, 9, 10) zum Zwischenspeichern von Daten, die dem tragbaren Datenträger (1) zum Einschreiben in den Speicher (6) übermittelt werden und
- einer Funktionalität zum alternierenden Einschreiben der übermittelten Daten in die Eingangspuffer (8, 9, 10) und zum alternierenden Auslesen der Eingangspuffer (8, 9, 10) und Einschreiben der ausgelesenen Daten in den Speicher (6), **dadurch gekennzeichnet,**
**dass** während eines ersten Zeitraums eine größere Zahl von Eingangspuffern (8, 9, 10) vorhanden ist als während eines zweiten Zeitraums.

8. Tragbarer Datenträger nach Anspruch 7, **dadurch gekennzeichnet, dass** das Einschreiben der übermittelten Daten in einen ersten Eingangspuffer (8) und das Auslesen eines vom ersten Eingangspuffer (8) verschiedenen zweiten Eingangspuffers (9) zeitlich überlappen.

9. Tragbarer Datenträger nach einem der Ansprüche 7 oder 8, **dadurch gekennzeichnet, dass** der Speicher (6) und die Eingangspuffer (8, 9, 10) als physikalisch unterschiedliche Speichermedien ausgebildet sind.

10. Tragbarer Datenträger nach einem der Ansprüche 7 bis 9, **dadurch gekennzeichnet, dass** in die Eingangspuffer (8, 9, 10) pro Zeiteinheit eine größere Datenmenge einschreibbar ist als in den Speicher (6).

11. Tragbarer Datenträger nach einem der Ansprüche 7 bis 10, **dadurch gekennzeichnet, dass** der Speicher (6) als ein nichtflüchtiges Speichermedium ausgebildet ist.

12. Tragbarer Datenträger nach einem der Ansprüche 7 bis 11, **dadurch gekennzeichnet, dass** die Eingangspuffer (8, 9, 10) jeweils als ein flüchtiges Speichermedium ausgebildet sind.

13. Tragbarer Datenträger nach einem der Ansprüche 7 bis 12, **dadurch gekennzeichnet, dass** die Eingangspuffer (8, 9, 10) als voneinander separierte Speicherbereiche ausgebildet sind.

14. Tragbarer Datenträger nach einem der Ansprüche 7 bis 13, **dadurch gekennzeichnet, dass** die Anzahl der Eingangspuffer (8, 9, 10) variiert.

15. Tragbarer Datenträger nach Ansprüche 7 bis 14, **dadurch gekennzeichnet, dass** während des zweiten Zeitraums ein einziger Eingangspuffer (8, 9, 10) vorhanden ist.

16. Tragbarer Datenträger nach einem der Ansprüche 7 bis 15, **dadurch gekennzeichnet, dass** der erste Zeitraum eine Produktionsphase umfasst, während der eine Initialisierung- und/oder Personalisierung des tragbaren Datenträgers (1) durchgeführt wird, und der zweite Zeitraum auf den ersten Zeitraum folgt.

17. Tragbarer Datenträger nach einem der Ansprüche 7 bis 16, **dadurch gekennzeichnet, dass** der tragbare Datenträger (1) für ein direktes Einschreiben der übermittelten Daten in die Eingangspuffer (8, 9,10) ohne vorgeschaltete Zwischenspeicherung und/oder für ein direktes Einschreiben der aus den Eingangspuffern (8, 9, 10) ausgelesenen Daten in den Speicher (6) ohne vorgeschaltete Zwischenspeicherung ausgelegt ist.

18. Tragbarer Datenträger nach einem der Ansprüche 7 bis 17, **dadurch gekennzeichnet, dass** der tragbare Datenträger (1) als eine Chipkarte ausgebildet ist.

## Claims

1. A method for writing data into a memory (6) of a portable data carrier (1), wherein
- first data are transmitted to the portable data carrier (1) and written into a first input buffer (8) of the portable data carrier (1),
- second data are transmitted to the portable data carrier (1) and written into a second input buffer (9) of the portable data carrier (1), and
- at least a portion of the first data are read out from the first input buffer (8) and written into the memory (6) while the second data are transmitted to the portable data carrier (1) and written into the second input buffer (9) of the portable data carrier (1), **characterised in that** the data are transmitted to the portable data carrier (1) and written into the memory (6) within the context of an initialisation and/or a personalisation of the portable data carrier (1), and **in that** the number of input buffers (8, 9, 10) is reduced after the execution of the initialisation and/or personalisation.

2. The method according to claim 1, **characterised in that** the data transmitted to the portable data carrier (1) are written directly into the first input buffer (8) or into the second input buffer (9) without prior intermediate storage.

3. The method according to any one of the preceding claims, **characterised in that** the data read out from the first input buffer (8) are written into the memory (6) without further intermediate storage.

4. The method according to any one of the preceding claims, **characterised in that** data blocks of different sizes are used for the transmission of the data to the portable data carrier (1) and for writing the data into the memory (6) of the portable data carrier (1).

5. The method according to any one of the preceding claims, **characterised in that** smaller data blocks are used for the transmission of the data to the portable data carrier (1) than for writing the data into the memory (6) of the portable data carrier (1).

6. The method according to any one of the preceding claims, **characterised in that** the number of input buffers (8, 9, 10) is reduced to a single input buffer (8, 9, 10).

7. A portable data carrier, comprising
- a memory (6),
- several at least temporarily existing input buffers (8, 9, 10) for the intermediate storage of data that are transmitted to the portable data carrier (1) for writing into the memory (6), and
- a functionality for alternately writing the transmitted data into the input buffers (8, 9, 10) and for alternately reading out the input buffers (8, 9, 10) and writing the read-out data into the memory (6),
**characterised in that**
a greater number of input buffers (8, 9, 10) exists during a first period of time than during a second period of time.

8. The portable data carrier according to claim 7, **characterised in that** the writing of the transmitted data into a first input buffer (8) and the reading out of a second input buffer (9) different from the first input buffer (8) overlap in time.

9. The portable data carrier according to any one of the claims 7 or 8, **characterised in that** the memory (6) and the input buffers (8, 9, 10) are configured as physically different memory media.

10. The portable data carrier according to any one of the claims 7 to 9, **characterised in that** a larger data volume can be written into the input buffers (8, 9, 10) per time unit than into the memory (6).

11. The portable data carrier according to any one of the claims 7 to 10, **characterised in that** the memory (6) is configured as a non-volatile memory medium.

12. The portable data carrier according to any one of the claims 7 to 11, **characterised in that** the input buffers (8, 9, 10) are each configured as a volatile memory medium.

13. The portable data carrier according to any one of the claims 7 to 12, **characterised in that** the input buffers (8, 9, 10) are configured as memory areas separated from one another.

14. The portable data carrier according to any one of the claims 7 to 13, **characterised in that** the number of the input buffers (8, 9, 10) varies.

15. The portable data carrier according to any one of the claims 7 to 14, **characterised in that** a single input buffer (8, 9, 10) exists during the second period of time.

16. The portable data carrier according to any one of the 7 to 15, **characterised in that** the first period of time comprises a production phase during which an initialisation and/ or personalisation of the portable data carrier (1) is carried out, and the second period of time follows the first period of time.

17. The portable data carrier according to any one of the claims 7 to 16, **characterised in that** the portable data carrier (1) is designed for directly writing the transmitted data into the input buffers (8, 9,10) without prior intermediate storage and/or for directly writing the data read out from the input buffers (8, 9, 10) into the memory (6) without prior intermediate storage.

18. The portable data carrier according to any one of the claims 7 to 17, **characterised in that** the portable data carrier (1) is configured as a chip card.

## Revendications

1. Procédé pour l'écriture de données dans une mémoire (6) d'un support de données portable (1), selon lequel
- des premières données sont transmises au support de données portable (1) et écrites dans un premier tampon d'entrée (8) du support de données portable (1),
- des deuxièmes données sont transmises au support de données portable (1) et écrites dans un deuxième tampon d'entrée (9) du support de données portable (1) et
- au moins une partie des premières données sont lue dans le premier tampon d'entrée (8) et écrites dans la mémoire (6) pendant que les deuxièmes données sont transmises au support de données portable (1) et écrites dans le deuxième tampon d'entrée (9) du support de données portable (1), **caractérisé par le fait**
**que** dans le cadre d'une initialisisation et/ ou d'une personnalisation du support de données portable (1), les données sont transmises au support de données portable (1) et écrites dans la mémoire (6) et que le nombre de tampons d'entrée (8, 9, 10) est réduit après l'exécution de l'initialisisation et/ ou de la personnalisation.

2. Procédé selon la revendication 1 **caractérisé par le fait que** les données transmises au support de données portable (1) sont écrites directement dans le premier tampon d'entrée (8) ou dans le deuxième tampon d'entrée (9) sans mise en mémoire intermédiaire préalable.

3. Procédé selon l'une des revendications précédentes **caractérisé par le fait que** les données lues dans le premier tampon d'entrée (8) sont écrites dans la mémoire (6) sans autre mise en mémoire intermédiaire.

4. Procédé selon l'une des revendications précédentes, **caractérisé par le fait que** pour la transmission des données au support de données portable (1) et pour l'écriture des données dans la mémoire (6) du support de données portable (1) on utilise des blocs de données de taille différente.

5. Procédé selon l'une des revendications précédentes, **caractérisé par le fait que** pour la transmission des données au support de données portable (1) on utilise de plus petits blocs de données que pour l'écriture des données dans la mémoire (6) du support de données portable (1).

6. Procédé selon l'une des revendications précédentes, **caractérisé par le fait que** le nombre de tampons d'entrée (8, 9, 10) est réduit à un seul tampon d'entrée (8, 9, 10).

7. Support de données portable avec
- une mémoire (6),
- plusieurs tampons d'entrée (8, 9, 10) présents tout au moins temporairement et servant de mémoire intermédiaire aux données qui sont transmises au support de données portable (1) pour être écrites dans la mémoire (6) et
- une fonctionnalité pour l'écriture alternée des données transmises aux tampons d'entrée (8, 9, 10) et pour la lecture alternée des tampons d'entrée (8, 9, 10) et l'écriture dans la mémoire (6) des données lues,
**caractérisé par le fait que**
pendant une première période les tampons d'entrée (8, 9, 10) sont présents en plus grand nombre que pendant une deuxième période.

8. Support de données portable selon la revendication 7, **caractérisé par le fait que** l'écriture des données transmises dans un premier tampon d'entrée (8) et la lecture d'un deuxième tampon d'entrée (9) différent du premier tampon d'entrée (8) se chevauchent dans le temps.

9. Support de données portable selon l'une des revendications 7 ou 8, **caractérisé par le fait que** la mémoire (6) et les tampons d'entrée (8, 9, 10) sont constitués de médias physiques différents.

10. Support de données portable selon l'une des revendications 7 à 9, **caractérisé par le fait que**, par unité de temps, l'on peut écrire une plus grande quantité de données dans les tampons d'entrée (8, 9, 10) que dans la mémoire (6).

11. Support de données portable selon l'une des revendications 7 à 10, **caractérisé par le fait que** la mémoire (6) est constituée d'un média non volatile.

12. Support de données portable selon l'une des revendications 7 à 11, **caractérisé par le fait que** les tampons d'entrée (8, 9, 10) sont chacun constitués d'un média volatile.

13. Support de données portable selon l'une des revendications 7 à 12, **caractérisé par le fait que** les tampons d'entrée (8, 9, 10) sont des zones mémoires séparées les unes des autres.

14. Support de données portable selon l'une des revendications 7 à 13, **caractérisé par le fait que** le nombre des tampons d'entrée (8, 9, 10) varie.

15. Support de données portable selon les revendications 7 à 14, **caractérisé par le fait que** pendant la deuxième période, un seul tampon d'entrée (8, 9, 10) est présent.

16. Support de données portable selon l'une des revendications 7 à 15, **caractérisé par le fait que** la première période englobe une phase de production, pendant laquelle on exécute une initialisisation et/ ou une personnalisation du support de données portable (1), et que la deuxième période succède à la première période.

17. Support de données portable selon l'une des revendications 7 à 16, **caractérisé par le fait que** le support de données portable (1) est conçu pour une écriture directe des données transmises dans les tampons d'entrée (8, 9, 10) sans mise en mémoire intermédiaire en amont et/ ou pour une écriture directe dans la mémoire (6) des données lues dans les tampons d'entrée (8, 9, 10) sans sans mise en mémoire intermédiaire en amont.

18. Support de données portable selon l'une des revendications 7 à 17, **caractérisé par le fait que** le support de données portable (1) est constitué d'une carte à puce.
